# EUROPEAN PATENT APPLICATION

(11) **EP 4 790 439 A1**
(43) Date of publication of application: **12.08.2026**
(21) Application number: 25156559.4
(22) Date of filing: 07.02.2025
(51) Int. Cl.: G01R 31/385, G01R 31/389, G01R 31/367, G01R 31/392, G01R 31/396

(54) **BATTERY MEASUREMENT**

(71) Applicant: CeLLife Technologies Oy, 33840 Tampere (FI)
(72) Inventor: LUHTALA, Roni, 33100 TAMPERE (FI); MESSO, Tuomas, 33870 TAMPERE (FI); VARSAMÄKI, Teemu, 37550 LEMPÄÄLÄ (FI)
(74) Representative: Berggren Oy

(57) **Abstract**

According to an embodiment, a rechargeable battery assembly is provided, the battery assembly comprising: a battery module (110) comprising a plurality of cell units (111) connected in series between a first terminal (Nₐ) and a second terminal (N_{b}); a current shaping assembly (120, 140) selectively couplable to a current path through the battery module (110); and a measurement subsystem (130) arranged to carry out a measurement procedure in a course of operation of the rechargeable battery assembly (100), the measurement procedure comprising the measurement subsystem (130) arranged to: couple the current shaping assembly (120, 140) to said current path and operate the current shaping assembly (120, 140) to vary an electric current in said current path over a measurement period according to a switching sequence defined by a multi-frequency pseudo-random pulse sequence, PRPS, that represents a plurality of frequency components at a predefined frequency resolution within a predefined frequency range and that defines switching between different current levels as a function of time, obtain measurement data that comprises a respective indication of a respective cell-unit-specific voltage across each cell unit (111-k) of the plurality of cell units (111) as a function of time and an indication of the electric current in said current path as a function of time over the measurement period, derive a respective cell-unit-specific impedance of each cell unit (111-k) based on the measurement data, and determine, based on the derived impedances, at least one status indication that pertains to a condition of the battery module (110).

## Description

### TECHNICAL FIELD

The present invention relates to rechargeable batteries and, in particular, to a technique for monitoring characteristics of a rechargeable battery.

### BACKGROUND

A vast amount of electronic apparatuses and services rely on operating power supplied by a rechargeable battery. Traditionally, rechargeable batteries have been applied as sources of operating power in portable devices such as mobile phones and portable computing devices of other kind, portable power tools, electronic toys, etc., whereas more recently rechargeable batteries have also become an important power source for vehicles of various kind, including bicycles, scooters, motorcycles, cars, buses, trucks, etc. Moreover, rechargeable batteries have also found use as electricity storage units of uninterruptable power supplies (UPS) and as energy reserves applied for storing and supplying balancing power for electrical grids. Recent and continuing developments in battery technology are likely to further broaden the field of applications that make use of operating power supplied by rechargeable batteries.

Typically, a rechargeable battery assembly includes one or more battery modules, where each battery module comprises a plurality of cells arranged in series, in parallel, or in a mixture thereof to provide a desired voltage and capacity, where the cells of the battery module are typically substantially identical or at least similar to each other. Additionally, each battery module of the battery assembly is typically provided with a battery management system (BMS) for managing certain aspects of internal operation of the respective battery module, such as monitoring operational state of the battery module and/or protecting the battery module from operation that brings some of its operating parameters (e.g. voltage and/or current) outside safe operating area.

In a user point of view, important aspects characterizing a rechargeable battery assembly applied as a power supply for an electronic device or an electrical service include recharging time of the battery assembly, operation time of the device or service enabled by the battery assembly, and the ability of the battery assembly to withstand repeated recharging and discharging without significantly increasing the charging time and/or without significantly reducing the operation time enabled by the battery assembly. Such user-perceivable characteristics of a rechargeable battery assembly basically reflect characteristics of its one or more battery modules such as the capacity of the one or more battery modules (in terms of an amount of electrical energy they are able to store), a charging rate at which the one or more battery module can be recharged, a discharging rate at which the one or more battery module are typically discharged in the course of operation of the device or service, and battery life in terms of the number of charge-discharge cycles the one or more battery modules are able to tolerate until their capacity is reduced to a significant extent.

When considering the capacity reduction in a viewpoint of a single battery module of the battery assembly, repeated charge-discharge cycles, i.e. a repeated process of recharging the battery module and discharging the battery module to supply power to the electronic device or electrical service, result in gradually decreasing the capacity of the battery module. Moreover, mechanical stress occurring in the course of usage of the battery assembly may also cause minor damage that does not break the battery assembly or the battery module therein but that directly or indirectly contributes towards decreasing capacity of the battery module.

The capacity degradation in a battery module is typically not similar across the cells of the battery module, which may lead to a scenario where individual cells of the battery module that were originally substantially identical in capacity exhibit different capacities. Since the overall capacity of the battery module is in practice limited by its lowest-capacity cell, such an imbalance between respective capacities of the individual cells of the battery module results in degradation of the overall capacity of the battery module, which at some point is likely to render the battery module (and hence the battery assembly) virtually unusable, even though some of its cells may still have a good capacity. Moreover, the imbalance between respective capacities of the individual cells of the battery module typically results in speeding up the capacity degradation of those cells that have started to lose their capacity and, therefore, an early detection of a situation where one or more cells of the battery module have started losing their capacity is important in order to avoid causing severe performance issue or even causing damage to the battery module or to other components of the battery assembly.

### SUMMARY

It is an object of the present invention to provide a technique for monitoring operational status of a rechargeable battery assembly.

According to an embodiment, a rechargeable battery assembly is provided, the battery assembly comprising: a battery module comprising a plurality of cell units connected in series between a first terminal and a second terminal; a current shaping assembly selectively couplable to a current path through the battery module; and a measurement subsystem arranged to carry out a measurement procedure in a course of operation of the rechargeable battery assembly, the measurement procedure comprising the measurement subsystem arranged to: couple the current shaping assembly to said current path and operate the current shaping assembly to vary an electric current in said current path over a measurement period according to a switching sequence defined by a multi-frequency pseudo-random pulse sequence (PRPS) that represents a plurality of frequency components at a predefined frequency resolution within a predefined frequency range and that defines switching between different current levels as a function of time, obtain measurement data that comprises a respective indication of a respective cell-unit-specific voltage across each cell unit of the plurality of cell units as a function of time and an indication of the electric current in said current path as a function of time over the measurement period, derive a respective cell-unit-specific impedance of each cell unit based on the measurement data, and determine, based on the derived impedances, at least one status indication that pertains to a condition of the battery module.

The exemplifying embodiments of the invention presented in this patent application are not to be interpreted to pose limitations to the applicability of the appended claims. The verb "to comprise" and its derivatives are used in this patent application as an open limitation that does not exclude the existence of also unrecited features.

Some features of the invention are set forth in the appended claims. Aspects of the invention, however, both as to its construction and its method of operation, together with additional objects and advantages thereof, will be best understood from the following description of some example embodiments when read in connection with the accompanying drawings.

### BRIEF DESCRIPTION OF FIGURES

The embodiments of the invention are illustrated by way of example, and not by way of limitation, in the figures of the accompanying drawings, where
Figure 1A illustrates a block diagram of some components of a rechargeable battery assembly according to an example;
Figure 1B illustrates a block diagram of some components of a rechargeable battery assembly according to an example;
Figure 2A illustrates a block diagram of some components of a rechargeable battery assembly according to an example;
Figure 2B illustrates a block diagram of some components of a rechargeable battery assembly according to an example;
Figure 2C illustrates a block diagram of some components of a rechargeable battery assembly according to an example;
Figure 3 illustrates a method according to an example;
Figure 4 illustrates respective impedance curves for two cell units according to an example;
Figure 5 illustrates respective impedance curves for a plurality of cell units according to an example;
Figure 6 illustrates a block diagram of some components of a rechargeable battery assembly according to an example; and
Figure 7 illustrates a block diagram of some components of an apparatus according to an example.

### DESCRIPTION OF SOME EMBODIMENTS

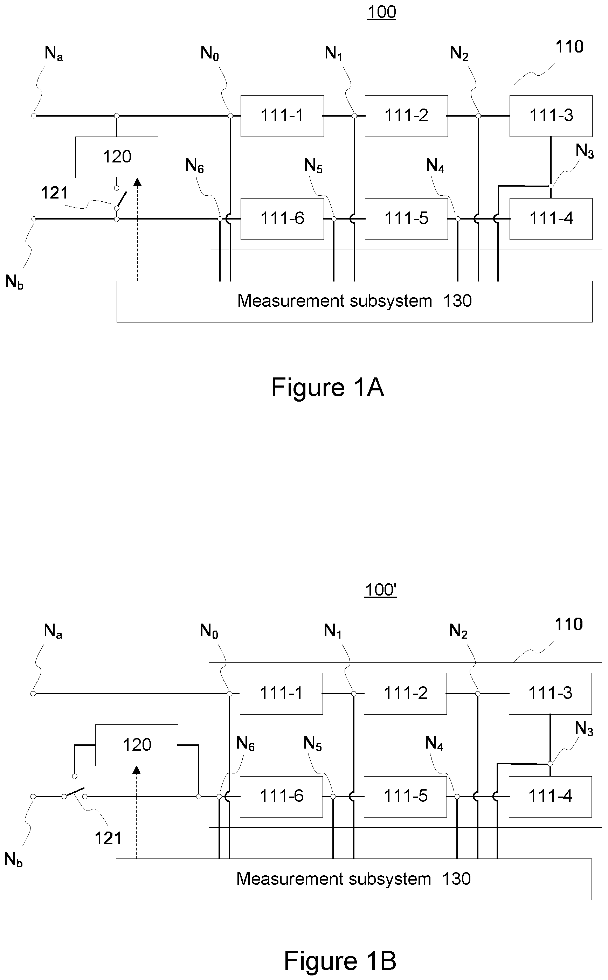

Figure 1A illustrates a block diagram of some components of a rechargeable battery assembly 100 according to an example, where the rechargeable battery assembly 100 is shown with a battery module 110, an adjustable load 120, and a measurement subsystem 130. Figure 1B illustrates a block diagram of some components of a rechargeable battery assembly 100' according to an example, which likewise comprises the battery module 110, the adjustable load 120, and the measurement subsystem 130, but where the adjustable load 120 is coupled to battery module 110 in a manner different from that of the rechargeable battery assembly 100 of the example of Figure 1A. In the following, each of the rechargeable battery assemblies 100, 100' may be also referred to, in short, as a battery assembly 100, 100' or simply as a battery 100, 100'.

In the respective illustrations of Figures 1A and 1B, the battery module 110 is shown with cell units 111-1, 111-2, ... 111-6 that represent a plurality of cell units of the battery module 110. In this regard, the plurality of cell units of the battery module 110 may be jointly referred to via a reference number 111, whereas any individual cell unit of the battery module 110 may be referred to via a reference number 111-k. The cell units 111-k of the battery module 110 are connected in series with each other between a first terminal Nₐ and a second terminal N_{b} of the battery assembly 100, 100'. In other words, the plurality of cell units 111 are connected in series in a current path between the first terminal Nₐ and the second terminal N_{b}. Herein, a current path through the battery module 110 is referred to in the following as a primary current path current path.

In an example, each cell unit 111-k comprises a single cell, whereas in another example each cell unit 111-k comprises a plurality of cells connected in parallel to each other. The cell units 111-k of the battery module 110 are preferably identical or at least similar to each other in their electrical characteristics upon construction of the battery assembly 100, 100', whereas the respective electrical characteristics of the individual cell unit 111-k of the battery module 110 typically change or degrade in the course of operation of the battery assembly 100, 100' and the change or degradation is typically different for each cell unit 111-k of the battery module 110. The cells of the battery module 110 may be provided using any suitable battery technology known in the art. In an example, the cells are provided as lithium-ion cells, whereas in other examples another battery technology, such as solid-state, lithium-sulfur or graphene-based batteries may be applied instead.

The adjustable load 120 is selectively couplable to the primary current path under control of the measurement subsystem 130. The adjustable load 120 is applicable as a current shaping assembly that enables introducing variations in an electric current in the primary current path to facilitate impedance measurements carried out on cell units 111-k of the battery module 110. In this regard, in the example of Figure 1A the adjustable load 120 is couplable between input/output nodes (or terminals) N₀ and N₆ of the battery module and hence in parallel with the battery module 110, whereas in the example of Figure 1B the adjustable load 120 is couplable between the battery module 110 and a predefined one of the first terminal Nₐ and the second terminal N_{b} and hence in series with the battery module 110. The adjustable load 120 has an adjustable impedance that may be set, selected and/or varied over time under control of the measurement subsystem 130, as will be described in the following via a number of examples.

The respective illustrations of Figures 1A and 1B further show the respective battery assembly 100, 100' with a switch 121 that is operated under control of the measurement subsystem 130 and that enables selectively coupling the adjustable load 120 to the primary current path and decoupling the adjustable load 120 from the primary current path. The switch 121 generalizes into any coupling mechanism that enables coupling the adjustable load 120 to the primary current path and decoupling the adjustable load 120 from the primary current path and that may be operated by the measurement subsystem 130, e.g. into a coupling circuit that comprises electrical components that implement one or more switches that enable coupling the adjustable load 120 to and decoupling the adjustable load from the primary current path.

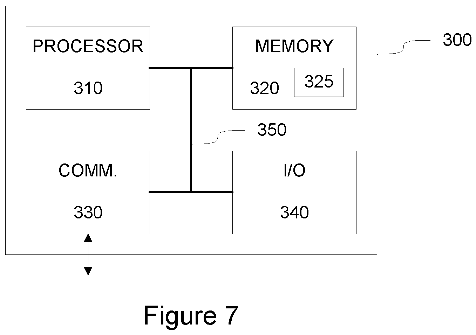

The measurement subsystem 130 is arranged to carry out a measurement procedure in the course of operation of the battery assembly 100, 100'. The measurement subsystem 130 may comprise a computer apparatus comprising a processor and a memory, where the memory is arranged to store program code that, when executed by the processor, causes the computer apparatus to operate as the measurement subsystem 130 according to the present disclosure. Implementation of the measurement subsystem 130 via operation of the computer apparatus is described in further detail later in this text with references to Figure 7.

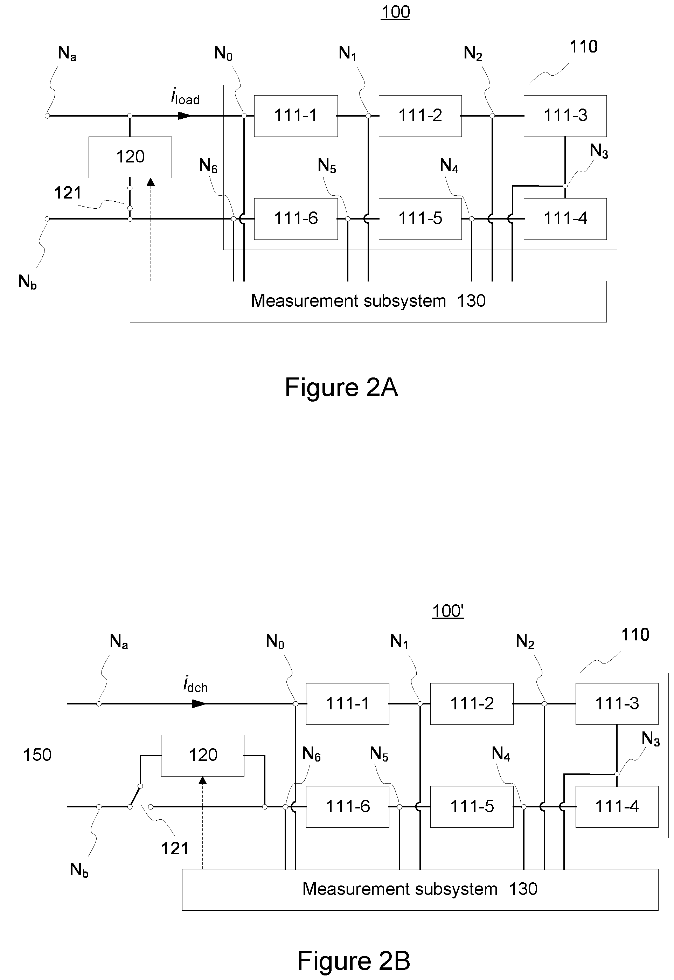

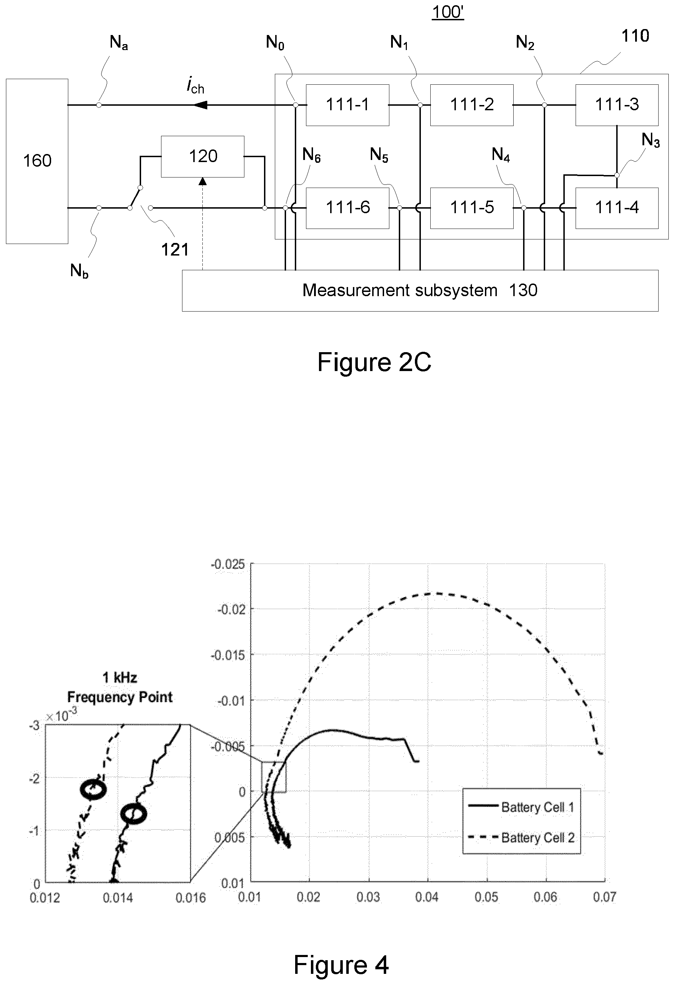

The aspect of the measurement subsystem 130 carrying out the measurement procedure in the course of operation of the battery assembly 100, 100' may comprise one of the following:
- Carrying out the measurement procedure when the battery assembly 100 is in a stand-by state, i.e. when no electrical energy transferred via the first and second terminals Nₐ, N_{b}, which results in drawing electrical energy from the battery module 110 to provide a measurement current *i*_{load} along the primary current path through the battery module 110, where the measurement current *i*_{load} varies in accordance with any changes in the impedance of the adjustable load 120. An example of such a scenario is illustrated in Figure 2A, where the adjustable load 120 of the battery assembly 100 is coupled to the primary current path (such that it is in parallel with the battery module 110).
- Carrying out the measurement procedure when an external load 150 is coupled to the first and second terminals **Nₐ, N_{b}** of the battery assembly 100', which results in supplying a discharging current *i*_{dch} along the primary current path through the battery module 110, where the discharging current *i*_{dch} varies in accordance with any changes in the impedance of the adjustable load 120. An example of such a scenario is illustrated in Figure 2B, where the adjustable load 120 of the battery assembly 100' is coupled to the primary current path (such that it is in series with the battery module 110).
- Carrying out the measurement procedure when an external source of electrical energy, e.g. a charger apparatus 160, is coupled to the first and second terminals **Nₐ, N_{b}** of the battery assembly 100', which results in supplying a charging current *i*_{ch} along the primary current path through the battery module 110, where the charging current *i*_{ch} varies in accordance with any changes in the impedance of the adjustable load 120.. An example of such a scenario is illustrated in Figure 2C, where the adjustable load 120 of the battery assembly 100' is coupled to the primary current path (such that it is in series with the battery module 110).

In a variation of the first one of the above examples described, e.g. the load 150 or the charger apparatus 160 may be coupled to the first and second terminals **Nₐ, N_{b}** of the battery assembly 100 with also the adjustable load 120 coupled to the primary current path, which results in the discharging current *i*_{dch} or the charging current *i*_{ch} (as applicable) along the primary current varying in accordance with any changes in the impedance of the adjustable load 120.

The measurement procedure may be carried out repeatedly in the course of operation of the battery assembly 100, 100' and the measurement procedure may be initiated, for example, according to a predefined schedule, in response to a command received at the measurement subsystem 130 and/or in response to detecting a predefined condition pertaining to the battery module 110. As an example of applying a predefined schedule for carrying out the measurement procedure, the measurement subsystem 130 may carry out the measurement procedure at predefined time intervals in consideration of operation time of the battery assembly, where operation time may include accumulated time of charging and/or discharging the battery module 110. In another example, application of a predefined schedule may involve the measurement subsystem 130 carrying out the measurement in consideration of charging-discharging cycles, e.g. at intervals of a predefined number of charging-discharging cycles. Non-limiting examples of commands that may trigger the measurement subsystem 130 to carry out the measurement procedure include a command originating from an external apparatus that is communicatively coupled to the battery assembly 100, 100' or to an apparatus using the battery assembly 100, 100' as its power source and a command received via a user interface associated with the battery assembly 100, 100' (e.g. one provided as part of the battery assembly 100, 100' or as part of the apparatus using the battery assembly 100, 100' as its power source). Non-limiting examples of a predefined condition that pertains to the battery module 110 are provided later in this text.

The measurement subsystem 130 is coupled to a plurality of nodes within the primary current path to monitor voltages within the battery module 110 at the respective nodes. The nodes under consideration may comprise input/output nodes of the battery module 110 and one or more intermediate nodes within the battery module 110, whereas respective indications of voltages at these nodes or indications of any voltages derived therefrom may be referred to as (part of) measurement data. The voltages in said nodes of the battery module 110 are applicable for deriving, e.g. by the measurement subsystem 130, a respective voltage across each of the cell units 111-k, which may be referred to as a respective cell-unit specific voltage. In the example illustrated in Figures 2A, 2B and 2C, the cell-unit specific voltages are derivable based on respective voltages at the following nodes:
- **N₀** and **N₆,** which denote the input/output nodes (or terminals) of the battery module 110;
- **N₁,** which denotes an intermediate node between the cell units 111-1 and 111-2;
- **N₂,** which denotes an intermediate node between the cell units 111-2 and 111-3;
- **N₃,** which denotes an intermediate node between the cell units 111-3 and 111-4;
- **N₄,** which denotes an intermediate node between the cell units 111-4 and 111-5; and
- **N₅,** which denotes an intermediate node between the cell units 111-5 and 111-6.

Hence, the cell-unit specific voltage across the cell unit 111-1 may be derived as a difference between respective voltages at the nodes **N₁** and **N₀,** the cell-unit-specific voltage across the cell unit 111-2 may be derived as a difference between respective voltages at the nodes **N₂** and **N₁** and so on. The measurement subsystem 130 may further derive an overall voltage across the series connection of the plurality of cell units 111, which in the example of Figures 2A, 2B and 2C may be derived as a difference between respective voltages at the nodes **N₆** and **N₀.** The illustrations of Figure 2A, 2B and 2C show an example that comprise six cell units 111-k, whereas derivation of the cell-unit-specific voltages and the overall voltage (if applicable) in the above-described manner generalizes into any number of cell units 111-k.

The measurement subsystem 130 may further receive an indication of an electric current in the primary current path. The indication of the electric current in the primary current path may be also considered as part of the measurement data. In various examples in the framework of the battery assembly 100, 100', the electric current through the plurality of cell units 111 may comprise the discharging current *i*_{dch} (cf. Figure 2B) or the charging current *i*_{ch} (cf. Figure 2C). The electric current in the primary current path may be measured using any current measurement arrangement known in the art (not illustrated in Figures 2A, 2B and 2C for graphical clarity).

The battery assembly 100, 100' typically further comprises a number of components not shown in the illustration of Figure 1, e.g. electrical connectors that couple the cells within each of the cell units 111-k to each other, electrical connectors that couple the cell units 111-k to each other and to the terminals **Nₐ, N_{b},** a housing for holding the (other) components of the battery assembly 100, 100', etc. The battery assembly 100, 100' may be provided as a component of a rechargeable battery pack that includes one or more battery assemblies 100, 100' and battery management system (BMS) that is arranged to control and/or monitor at least some aspects of the one or more battery assemblies 100, 100' of the battery pack. In an example, the measurement subsystem 130 of the battery assembly 100, 100' of the battery pack is provided as part of the BMS, whereas in another example the measurement subsystem 130 is provided separately from the BMS.

The battery pack may serve as a power supply for an electronic device or to an electrical service, whereas the capacity of the battery pack and its (other) electrical characteristics are chosen in view of the intended usage of the battery pack. In some examples, the battery pack is an integrated component of the electronic device or an apparatus providing the electrical service, whereas in other example the battery pack is provided as a separate entity that may be coupled to the electronic device or to the apparatus providing the electrical service. As a few non-limiting examples in this regard, the battery pack making use of the battery assembly 100, 100' may serve as a power supply to a handheld mobile computer device such as a mobile phone, a tablet computer or a laptop computer or to a portable electrical apparatus of other type, such as a gaming device, a music player, a navigation device, headphones or a headset, a camera, etc. In other examples, the battery pack may be one integrated to an electric or hybrid vehicle at least partially driven by electric power, such as a bicycle, a scooter, a motorcycle, a car, a bus, a truck, special-purpose vehicles employed e.g. in ports and in mining, etc. In further examples, the battery pack may serve as a component of an uninterruptible power supply (UPS) or a power bank apparatus that is connectable to the electronic device or to the apparatus providing the electrical service to supply power thereto.

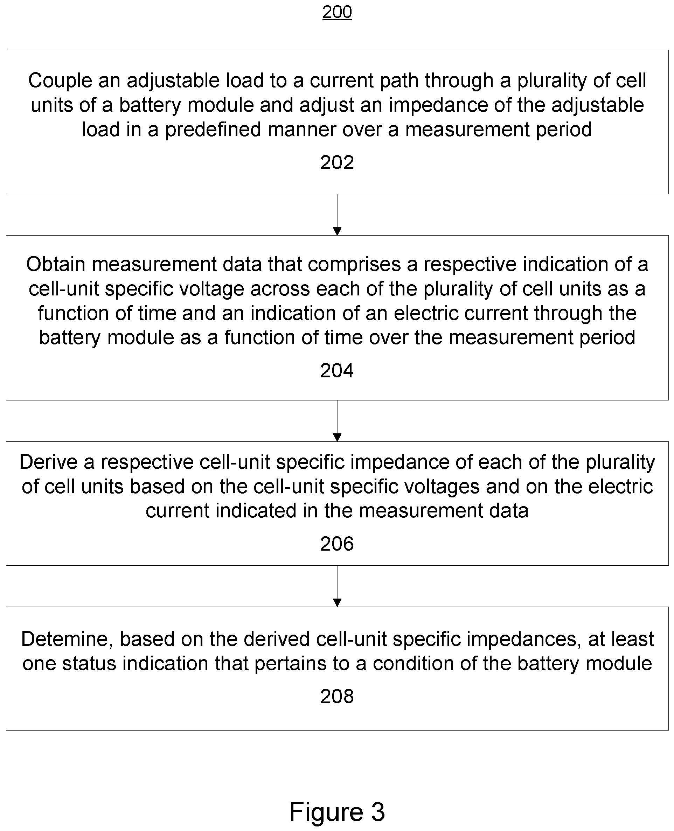

The measurement subsystem 130 may be arranged to carry out the measurement procedure in accordance with method 200 illustrated in Figure 3, where the method 200 comprises:
- coupling the adjustable load 120 to the primary current path through the plurality of cell units 111 of the battery module 110 and adjusting the impedance of the adjustable load 120 in a predefined manner over a measurement period (block 202);
- obtaining the measurement data that comprises the respective indication of the cell-unit specific voltage across each of the cell units 111-k as a function of time and the indication of the electric current through the battery module 110 as a function of time over the measurement period (block 204);
- deriving a respective cell-unit specific impedance of each of the cell units 111-k based on the cell-unit specific voltages and on the electric current indicated in the measurement data (block 206); and
- determining, based on the derived cell-unit specific impedances, at least one status indication that pertains to a condition of the battery module 110 (block 208).

The method 200 may be varied in a number of ways, e.g. in accordance with the examples pertaining to the structure and operation of elements of the battery assemblies 100, 100' provided in the foregoing and/or in accordance with the examples pertaining to the structure and operation of elements of the battery assemblies 100, 100' and their variants described in the following.

The aspect of coupling the adjustable load 120 to the primary current path (cf. block 202) may comprise the measurement subsystem 130 operating the coupling mechanism, e.g. the switch 121, to couple the adjustable load 120 to the primary current path as follows:
- In the battery assembly 100, the coupling mechanism is applicable for coupling the adjustable load 120 in parallel to the battery module 110, thereby coupling it to the current path from one of the first and second terminals **Nₐ, N_{b}** through the plurality of cell units 111 of the battery module 110 to another one of the first and second terminals **Nₐ, N_{b}.**
- In the battery assembly 100', the coupling mechanism is applicable for coupling the adjustable load 120 in series with the battery module 110, thereby coupling it as a component that is along the current path from one of the first and second terminals **Nₐ, N_{b}** through the plurality of cell units 111 of the battery module 110 to another one of the first and second terminals **Nₐ, N_{b}.**

Conversely, once measurement procedure is completed, the measurement subsystem 130 may operate the coupling mechanism to decouple the adjustable load 120 from the primary current path.

The aspect of adjusting the impedance of the adjustable load 120 in a predefined manner (cf. block 202) may comprise the measurement subsystem 130 operating the adjustable load 120 to switch its impedance between two or more predefined values according to a switching sequence over the measurement period. The switching sequence is defined by a multi-frequency pseudo-random pulse sequence (PRPS), which represents a plurality of frequency components at a predefined frequency resolution within a predefined frequency range and, hence, the switching sequence defines switching the impedance of the adjustable load 120 between the two or more predefined values as a function of time during the measurement period.

The measurement subsystem 130 operating the adjustable load 120 to vary its impedance between the two or more predefined values results in an electric current in the primary current path changing accordingly between two or more current levels in dependence of a voltage across the battery module 110. Along the lines described above, an indication of the electric current in the primary current path may be obtained from the current measurement arrangement provided in the primary current path, whereas the voltage across the battery module 110 is derivable as a difference between respective voltages at the nodes **N₆** and **N₀.**

The perturbations in the electric current in the primary current path caused by the corresponding changes in the impedance of the adjustable load 120 over time result in corresponding changes in the voltage across the battery module 110. Consequently, the impedance of the battery module 110 over time may be obtained as a ratio of the voltage across the battery module 110 over time and the electric current in the primary current path over time, e.g. as.

Using Fourier techniques known in the art for transforming the voltage across the battery module 110 over time and the electric current in the primary current path over time to the frequency domain, it is possible to determine the impedance of the battery module 110 across the frequency range of interest as a function of frequency. Moreover, while described above for the battery module 110 in its entirety, similar considerations are valid for each cell unit 111-k of the battery module 110. Hence, the perturbations in the electric current in the primary current path through the battery module 110 caused by the changes in the impedance of the adjustable load 120 also result in corresponding changes in respective voltages across the cell units 111-k of the battery module 110 and, consequently, the respective cell-unit specific impedances over time are derivable as a respective ratio of the voltage across the respective cell unit 111-k over time and the electric current in the primary current path over time, whereas the Fourier techniques are useable for transforming the cell-unit-specific voltages and the electric current in the primary current path to the frequency domain and determining respective cell-unit-specific impedances across the frequency range of interest as a function of frequency.

The PRPS that defines the switching sequence for switching the impedance of the adjustable load 120 between the two or more predefined values may comprise, for example, a multi-frequency pseudo-random binary sequence (PRBS) or a multi-frequency pseudo-random ternary sequency (PRTS). Some characteristics of such switching sequences for impedance measurement purposes together with non-limiting examples of implementing the adjustable load 120 are described e.g. in a passage from paragraph [0028] to paragraph [0037] of a European patent publication no. 4278196 B1 with references to its Figures 2 to 6, which passage and Figures are incorporated herein by reference. Along the lines described therein, according to an example, the PRPS that defines the switching sequence

The measurement subsystem 130 may derive the multi-frequency PRPS that serves as basis for the switching sequence, for example, via using one or more predefined rules that enable deriving the multi-frequency PRPS according to one or more pulse sequence parameters. As an example in this regard, the pulse sequence parameters may define one or more of the following characteristics of the PRPS: the length of the sequence, the frequency content of the sequence, pulse amplitudes applied in the sequence (in time domain), etc. In another example, the measurement subsystem 130 may comprise or otherwise have access to a memory that stores one or more predefined PRPSs of desired characteristics and, consequently, generation of the PRPS may comprise the controller 122 reading the PRPS to be applied from the memory.

Coupling the adjustable load 120 to the primary current path and varying the impedance of the adjustable load 120 over time according to the switching sequence when electrical energy is transferred via the first and second terminals **Nₐ, N_{b}** results in minor variations in the current supplied along the primary current path (e.g. the measurement current *i*_{load}, the discharging current *i*_{dch}, or to the charging current *i*_{ch}) during the measurement period. However, with a suitable selection of the impedance values applied for the adjustable load 120, the resulting disturbances in the overall current in the primary current path can be kept small enough in order not to disturb the transfer of electrical energy via the first and second terminals **Nₐ, N_{b}:** significant variations in the electric current in the primary current path are avoided via applying relatively high impedance values for the adjustable load 120 coupled in parallel to battery module 110 and via applying relatively small impedance values for the adjustable load 120 coupled in series with the battery module 110.

The aspect of obtaining the measurement data that pertains to the battery module 110 (cf. block 204) may comprise reading the respective voltages at the input/output nodes of the battery module 110 and at the intermediate nodes within the battery module 110 for a plurality of time instants within the measurement period and using these voltages to compute the respective cell-unit specific voltage for each cell unit 111-k for the plurality of time instants, thereby deriving, for each cell unit 111-k, respective voltage data that is descriptive of the respective cell-unit specific voltage as a function of time over the measurement period.

The aspect of obtaining the measurement data that pertains to the battery module 110 further comprises the measurement subsystem 130 receiving an indication of the electric current in the primary current path. Along the lines described in the foregoing, the measurement subsystem 130 may receive the indication of the electric current from the current measurement arrangement arranged in the primary current path. In this regard, the measurement subsystem 130 may receive a respective indication of the electric current for a plurality of time instants within the measurement period, thereby deriving current data that is descriptive of the electric current in the primary current path as a function of time over the measurement period.

The aspect of deriving the respective cell-unit specific impedance for each of the cell units 111-k (cf. block 206) may comprise deriving the cell-unit specific impedances based on the measurement data that comprise the respective cell-unit specific voltages for the plurality of cell units 111 and the electric current in the primary current path for the measurement period. In particular, the measurement subsystem 130 may apply the cell-unit specific voltage data and the current data to derive, for each cell unit 111-k, a respective impedance for the plurality of time instances within the measurement period. Hence, derivation of the cell-unit specific impedances results in deriving, for each cell unit 111-k, respective impedance data that is descriptive of the impedance of the respective cell unit 111-k as a function of time over the measurement period.

An applicable duration for the switching sequence and hence for the duration measurement period depends on the frequency range of interest represented by the applied switching sequency. In general, the frequency range of interest may extend from frequency *f*ₘᵢₙ to frequency *f*ₘₐₓ, where in non-limiting examples the frequency range of interest may extend, for example, from a fraction of one Hz up to a few kHz, where the lower end of the frequency range may be, for example, in a range from 0.01 to 1 Hz and where the upper end of the frequency range may be, for example, in a range from 4 to 5 kHz. According to an example, the duration *T*ₘ of the measurement period may be chosen in view of a desired value of the frequency *f*ₘᵢₙ that serves as the lower end of the frequency range of interest, e.g. as *T*ₘ = 1 / *f*ₘᵢₙ, whereas in another example the frequency *f*ₘᵢₙ may be chosen in view of the desired measurement time *T*ₘ. The upper end *f*ₘₐₓ of the frequency range of interest may be chosen in view of the generation frequency *f*_{gen} of the multi-frequency PRPS serving as the switching sequence, e.g. as *f*ₘₐₓ = *f*_{gen} 12. In various examples, an applicable duration of the measurement period may be in a range from 0.5 to 10 seconds.

Along the lines described in the foregoing, the PRPS that serves as the basis for the switching sequence represents a predefined frequency range, which translates into corresponding frequency range being represented by the current data and by the respective voltage data obtained for the plurality of cell units 111 as well as by the respective impedance data derived for the plurality of cell units 111. Consequently, the aspect of determining the at least one status indication based on the derived cell-unit specific impedances (cf. block 208) may comprise the measurement subsystem 130 applying the respective impedance data derived for the plurality of cell units 111 to derive, for each cell unit 111-k, a respective impedance curve that represents the impedance of the respective cell-unit 111-k as a function of frequency over the frequency range of interest and determining a respective status indication for one or more cell units 111-k based on the derived impedance curves.

The impedance curve derived for a cell unit 111-k may be defined as a curve in the complex plane, which defines the real part and the imaginary part of the impedance of the respective cell unit 111-k for a plurality of frequency points within the frequency range of interest, where the real part represents resistance of the respective cell unit 111-k and the imaginary part represents the reactance of the respective cell unit 111-k at the plurality of frequency points. Such representation and/or illustration of an impedance curve may be also referred to as a Nyquist plot of the impedance curve. The impedance curves derived based on the single measurement procedure that simultaneously covers the frequency range of interest provides a comprehensive and reliable measure of the condition of the respective cell unit 111-k that facilitates reliable detection of any shortcomings in condition and/or performance of the respective cell unit 111-k that may go undetected e.g. if considering the impedance via a sequence of separate measurements carried out for the plurality of frequency points. The complex-plane impedance curve determined for a cell unit 111-k may be also referred to as an electrical fingerprint (EFP) of the respective cell-unit 111-k.

While the complex-plane impedance curve derived for a cell unit 111-k is directly or indirectly indicative of various aspects of condition of the respective cell unit 111-k, certain impedance characteristics derivable from the complex-plane impedance curve are readily useable for estimating the (remaining) capacity of the respective cell unit 111-k in general. Moreover, the impedance characteristics derivable from the complex-plane impedance curve derived for a cell unit 111-k are also useable for estimating its current (remaining) capacity in comparison to its (remaining) capacity at an earlier point in time or in comparison to a (remaining) capacity of another cell unit 111-k of the battery module 111 via comparing the impedance characteristics derived for the respective cell unit 111-k to those derived therefor at said earlier point of time or to those derived for the other cell unit 111-k of the battery module 110 (as applicable). Yet further, the (remaining) overall capacity of the battery module 110 is also derivable based on the respective cell-unit specific impedance curves derived for the individual cell-units 111-k.

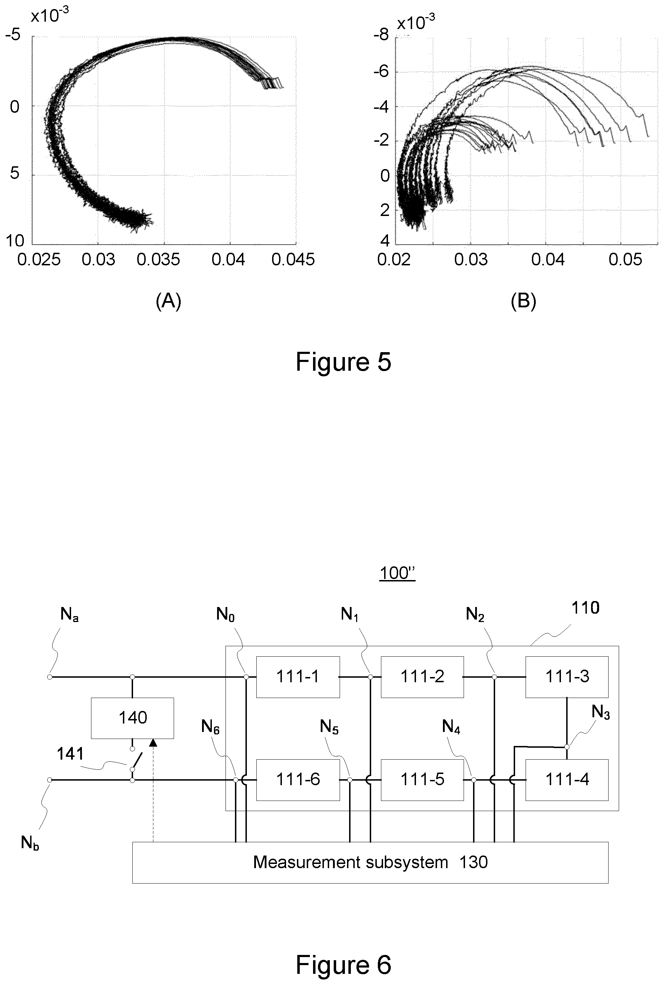

In this regard, Figure 4 provides an example concerning different shapes of the complex-plane impedance curves derived for two cell-units having different (remaining) capacities via illustrating respective complex-plane impedance curves derived for a first cell that has a good remaining capacity and that can be assumed to be in good condition (the solid curve) and for a second cell that has compromised capacity and that can be assumed be in a less-than-good condition (the dashed curve). As shown in the illustration of Figure 4, the respective impedance curves derived for the good-capacity cell and the compromised-capacity cell have very different overall shapes in the complex plane, even though e.g. at and close to 1 kHz point their impedances appear similar to each other. As another example in this regard, the illustration (A) of Figure 5 depicts a plurality of complex-plane impedance curves derived for a respective plurality of cell units that are substantially similar to each other in their (remaining) capacity and that are hence safely useable as the cell units of the battery module 110, whereas the illustration (B) of Figure 5 depicts a plurality of complex-plane impedance curves derived for a respective plurality of cell units that are substantially different from each other in their (remaining) capacity and that are hence run a potential safety risk if applied as the cell units of the battery module 110.

According to an example, the aspect of determining the respective status indications for the one or more cell units 111-k based on the derived impedance curves comprises the measurement subsystem 130 determining the respective status indication for each of the plurality of cell units 111 as the respective impedance curve determined therefor (i.e. using the respective impedance curves determined for the plurality of cell units 111 as respective status indications) and storing data that represents the impedance curves to a memory within the battery assembly 110 (e.g. to the memory of the computer apparatus applied for implementing the measurement subsystem 130). Additionally or alternatively, the measurement subsystem 130 may transmit the data that represents the impedance curves to one or more other apparatuses, e.g. to one or more apparatuses arranged to provide a cloud computing service. Consequently, the impedance curves serving as the status indication data are applicable for subsequent monitoring and analysis of the changes in the respective impedances of the plurality of cells 111 of the battery module 110 over time, thereby facilitating e.g. quality control and/or subsequent analysis of possible malfunctions at the cell unit level.

According to an example, the aspect of determining the respective status indications for the one or more cell units 111-k based on the derived impedance curves comprises the measurement subsystem 130 carrying out the following:
- deriving respective one or more impedance characteristics for each cell unit 111-k based on the impedance curve determined therefor, and
- determining, in response to the one or more impedance characteristics derived for a given cell unit 111-k deviating from respective one or more reference impedance characteristics, a respective status indication that indicates compromised condition of the respective cell unit 111-k.

In an example, the one or more reference impedance characteristics are predefined one or more reference impedance characteristics, e.g. ones derived from an impedance curve that represents an initial impedance curve of the cell-units 111-k upon construction of the battery module 110. In such an example, the status indication regarding a compromised condition of a given cell unit 111-k may be issued in response to the one or more impedance characteristics derived for the given cell unit 111-k indicated a change from their respective initial values (e.g. a change the exceeds a respective predefined threshold).

In another example, the one or more reference impedance characteristics are one or more representative impedance characteristics determined based on the respective one or more impedance characteristics derived for the plurality of cell units 111 (in the same measurement procedure). In this example, the one or more reference impedance characteristics may be ones that represent the respective impedance characteristics of a majority of the cell units 111-k and hence the status indication regarding a compromised condition of a given cell unit 111-k may be issued in response to the one or more impedance characteristics derived for the given cell unit 111-k indicate a difference to the respective representative impedance characteristic (e.g. a difference the exceeds a respective predefined threshold). As a non-limiting example, the one or more reference impedance characteristics may be ones that represent the respective impedance characteristics of a majority of the cell units 111-k may be derived as an average, as a median or as another statistical measure of the respective impedance characteristic derived for the plurality of cell units 111.

The one or more impedance characteristic considered in determination of the status indication in the examples above may comprise, for example, one or more of the following:
- the number of partially circular segments in the complex-plane impedance curve;
- respective frequency sub-ranges at which the partially circular segments in the complex-plane impedance curve appear;
- elevated imaginary part of the complex-plane impedance curve at a low frequency sub-range;
- frequencies at which local minima and/or local maxima of the impedance appear;
- respective minima and/or maxima of the resistance within one or more frequency sub-ranges;
- respective minima and/or maxima of the reactance within one or more frequency sub-ranges;
- impedance as a function of frequency;
- an overall shape of the complex-plane impedance curve;
- respective diameters of the partially circular segments in the complex-plane impedance curve.

Hence, some of the impedance characteristics described above are considered across the frequency range of interest in its entirety, whereas some of the impedance characteristics are considered at one or more frequency sub-ranges of the frequency range of interest, e.g. at one or more of the low frequency sub-range, the middle frequency sub-range and the high frequency sub-range, which may be defined e.g. as follows:
- the low frequency sub-range from 0.01 to 5 Hz,
- the middle frequency sub-range from 5 to 500 Hz,
- the high frequency sub-range from 500 Hz to 5 kHz.

The operations described in the foregoing for the method 200 may further comprise the measurement subsystem 130 conveying information about the determined at least one status indication to a user and/or to one or more other apparatuses, e.g. to one or more apparatuses arranged to provide a cloud computing service. Non-limiting examples of the measurement subsystem 130 conveying the at least one status indication include the following:
- displaying the determined at least one status indication via a user interface of the battery assembly 100, 100',
- transmitting the determined at least one status indication to one or more other apparatuses for storage, analysis and/or presentation to a user therein,
- storing the determined at least one status indication to a memory within the battery assembly 100, 100' for subsequent analysis and/or presentation to a user via the user interface of the battery assembly 100, 100' e.g. in response to a user command received via the user interface.

In addition to or instead of serving basis for determination of the at least one status indication, the respective one or more impedance characteristics derived for the plurality of cell units 111 may be stored to a memory within the battery assembly 100, 100' for subsequent analysis and/or they may be transmitted to one or more other apparatuses (e.g. to a cloud computing service) for subsequent analysis, thereby facilitating e.g. quality control and/or subsequent analysis of possible malfunctions at the cell unit level.

Along the lines described in the foregoing, the measurement procedure may be initiated according to a predefined schedule, in response to a command received at the measurement subsystem 130, or in response to the measurement subsystem 130 detecting a predefined condition that pertains to the battery module 110, thereby enabling carrying out the measurement procedure repeatedly in order to monitor changes in operational status of the battery module 110 over time. An example of initiating the measurement procedure in response to a predefined condition that pertains to the battery module 110, the measurement subsystem 130 is arranged to carry out the following:
- obtain a respective indication of a respective cell-unit specific voltage across each cell unit 111-k of the plurality of cell units 111 for a given time instant,
- compare the obtained cell-unit specific voltages for the given time instant to a reference voltage, and
- initiate the measurement procedure in response to at least one cell-unit specific voltage differing from the reference voltage by more than a predefined margin.

In various examples, the reference voltage may be a predefined reference voltage (set e.g. upon construction of the battery assembly 100, 100'), an average of the cell-unit specific voltages for the given time instant, a median of the cell-unit specific voltages for the given time instant, or a voltage derived by dividing a voltage across the plurality of cell units 111 at the given time instant by the number of cell units 111-k in the battery module 110.

Figure 6 illustrates a block diagram of some components of a rechargeable battery assembly 100" according to an example. Along the lines described for the rechargeable battery assemblies 100, 100', also the rechargeable battery assembly 100" may be referred to, in short, as a battery assembly 100" or simply as a battery 100". The battery assembly 100" is similar to the battery assembly 100 in that it comprises the battery module 110 and the measurement subsystem 130 described in the foregoing, whereas the battery assembly 100" further comprises a temporary charge storage 140 for generating an electric current that either contributes to the overall current in the primary current path or serves a measurement current in the primary current path.

The temporary charge storage 140 is selectively couplable to the primary current path under control of the measurement subsystem 130. The temporary charge storage 140 is applicable as a current shaping assembly that enables introducing variations in an electric current in the primary current path to facilitate impedance measurements carried out on cell units 111-k of the battery module 110. In this regard, the temporary charge storage 140 is couplable between the input/output nodes (or terminals) N₀ and N₆ of the battery module and hence in parallel with the battery module 110. When coupled to the primary current path, the temporary charge storage 140 is applicable for generating a measurement current that results in a corresponding change in the electric current in the primary current path and hence through the battery module 110.

The illustration of Figure 6 further shows the battery assembly 100" with a switch 141 that is operated under control of the measurement subsystem 130 and that enables selectively coupling the temporary charge storage 140 to the primary current path and decoupling the temporary charge storage 140 from the primary current path. The switch 141 generalizes into any coupling mechanism that may be operated by the measurement subsystem 130, e.g. a coupling circuit that comprises electrical components that implement one or more switches that enable coupling the temporary charge storage 140 to and decoupling the temporary charge storage 140 from the primary current path. The measurement subsystem 130 may selectively operate the temporary charge storge 140, when coupled to the primary current path, in one of the following operation modes to provide a corresponding contribution to the electric current in the primary current path:
- operate the temporary charge storage 140 to discharge electrical energy from the battery module 110 for storage in the temporary charge storage 140,
- operate the temporary charge storage 140 to discharge electrical energy from the temporary charge storage 140 for storage in the battery module 110,
- refrain from transferring electrical energy between the battery module 110 and the temporary charge storage 140.

In particular, when carrying out the method 200 using the battery assembly 100" instead of the battery assembly 100 or the battery assembly 100', the following modifications are applied:
- The aspect of coupling the adjustable load 120 to the primary current path (cf. block 202) is replaced by coupling the temporary charge storage 140 to the primary current path. This may comprise, for example, the measurement subsystem 130 operating the coupling mechanism, e.g. the switch 141, to couple the temporary charge storage 140 to the primary current path.
- The aspect of adjusting the impedance of the adjustable load 120 in a predefined manner (cf. block 202) is replaced by the measurement subsystem 130 alternating between at least two of the above-described operation modes according to a switching sequence over the measurement period.

Herein, the switching sequence that defines the alternation is defined by a PRPS, which represents a plurality of frequency components at a predefined frequency resolution within a predefined frequency range and, hence, the switching sequence defines alternating between at least two operation modes as a function of time during the measurement period. Moreover, said alternating between at least two of the above-described may comprise alternating between any two of the three operation modes described above to provide a PRBS or said alternating between at least two of the above-described may comprise alternating between the three operation modes described above to provide a PRTS.

According to an example, the temporary charge storage 140 comprises one or more capacitors that are selectively couplable between the input/output nodes (or terminals) N₀ and N₆ of the battery module 110 and that are able to receive electrical energy from the battery module 110 and supply electrical energy to the battery module 110. In such an example, the temporary charge storage 140 further comprises an internal control circuit that controls respective voltages at the one or more capacitors in accordance with control information received from the measurement subsystem 130 to set the temporary charge storage to a desired operation mode in terms of transferring electrical energy to or from the one or more capacitors.

In some examples, the measurement subsystem 130 applies the temporary charge storage 140 in a scenario where the measurement procedure is to be carried when the battery module 100 of the battery assembly 100" does not supply or receive an electric current through the first and second terminals Nₐ, N_{b}, e.g. when the battery assembly 100" is not coupled to the external load 150 to provide the discharging current *i*_{dch} to the primary current path or to the charger apparatus 160 to provide the charging current *i*_{ch} to the primary current path. In such scenarios, the current supplied via the above-described operation of the temporary charge storage 140 serves as the measurement current provided in the primary current path. In other examples, the measurement subsystem 130 applies the temporary charge storage 140 concurrently with the external load 150 or the charger apparatus 160 being coupled to the first and second terminals Nₐ, N_{b}, thereby introducing the measurement current component generated via the above-described operation of the temporary charge storage 140 to the primary current path on top of the discharging current *i*_{dch} or the charging current *i*_{ch} (as applicable).

While the examples described above refer to three different operation modes of the temporary charge storage 140 and application of two or three of these operation modes for introducing variations to the electric current in the primary current path accordingly to provide a PRBS or a PRTS, in other examples the temporary charge storage 140 may further operation modes via adjusting the current supplied thereto and/or therefrom in operation modes that involve, respectively, charging and/or discharging the temporary charge storage 140. Such examples enable switching sequences for altering the electric current in the primary current path between more than three levels to provide a PRPS having more than three different levels.

The temporary charge storage 140 of the battery assembly 100" is an additional component that is not required in the battery assemblies 100, 100' and hence brings a minor additional complexity in implementation of the battery assembly 100". In this regard, the battery assemblies 100, 100' base the measurement procedure in drawing a small amount of electrical energy from the battery module 110, which results in reducing the charge level of the battery module 110 by a corresponding amount as well as in the electrical energy drawn from the battery module 110 converting into heat in the adjustable load 120 (which in turn may require a design and/or an arrangement that ensures keeping the temperature of the battery assembly 100, 100' low enough). In contrast, the temporary charge storage 140 of the battery assembly 100" enables carrying out the measurement procedure without drawing electrical energy from the battery module 110 and hence substantially without affecting the charge level of the battery module 110. Moreover, usage of the temporary charge storage 140 enables a design that results in a reduced heat generation in the adjustable load 120 during the measurement procedure.

Figure 7 illustrates a block diagram of some components of an apparatus 300 that may be employed to implement at least some aspects of the measurement subsystem 130 described in the foregoing. The apparatus 300 comprises a processor 310 and a memory 320. The memory 320 may store data and computer program code 325. The apparatus 300 may further comprise communication means 330 for wired or wireless communication with other apparatuses and/or user I/O (input/output) components 340 that may be arranged, together with the processor 310 and a portion of the computer program code 325, to provide the user interface for receiving input from a user and/or providing output to the user. In particular, the user I/O components may include user input means, such as one or more keys or buttons, a keyboard, a touchscreen or a touchpad, etc. The user I/O components may include output means, such as a display or a touchscreen. The components of the apparatus 300 are communicatively coupled to each other via a bus 350 that enables transfer of data and control information between the components.

The memory 320 and a portion of the computer program code 325 stored therein may be further arranged, with the processor 310, to cause the apparatus 300 to perform at least some aspects of operation of the measurement subsystem 130. The processor 310 is configured to read from and write to the memory 320. Although the processor 310 is depicted as a respective single component, it may be implemented as respective one or more separate processing components. Similarly, although the memory 320 is depicted as a respective single component, it may be implemented as respective one or more separate components, some or all of which may be integrated/removable and/or may provide permanent / semi-permanent/ dynamic/cached storage.

The computer program code 325 may comprise computer-executable instructions that implement at least some aspects of operation of the measurement subsystem 130when loaded into the processor 310. As an example, the computer program code 325 may include a computer program consisting of one or more sequences of one or more instructions. The processor 310 is able to load and execute the computer program by reading the one or more sequences of one or more instructions included therein from the memory 320. The one or more sequences of one or more instructions may be configured to, when executed by the processor 310, cause the apparatus 300 to perform at least some aspects of operation of the measurement subsystem 130. Hence, the apparatus 300 may comprise at least one processor 310 and at least one memory 320 including the computer program code 325 for one or more programs, the at least one memory 320 and the computer program code 325 configured to, with the at least one processor 310, cause the apparatus 300 to perform at least some aspects of operation of the measurement subsystem 130.

The computer program code 325 may be provided e.g. as a computer program product comprising at least one computer-readable non-transitory medium having the computer program code 325 stored thereon, which computer program code 325, when executed by the processor 310 causes the apparatus 300 to perform at least some aspects of operation of the measurement subsystem 130. The computer-readable non-transitory medium may comprise a memory device or a record medium that tangibly embodies the computer program. As another example, the computer program may be provided as a signal configured to reliably transfer the computer program.

Reference(s) to a processor herein should not be understood to encompass only programmable processors, but also dedicated circuits such as field-programmable gate arrays (FPGA), application specific circuits (ASIC), signal processors, etc. Features described in the preceding description may be used in combinations other than the combinations explicitly described.

## Claims

1. A rechargeable battery assembly (100, 100', 100") comprising:
a battery module (110) comprising a plurality of cell units (111) connected in series between a first terminal **(Nₐ)** and a second terminal **(N_{b});**
a current shaping assembly (120, 140) selectively couplable to a current path through the battery module (110); and
a measurement subsystem (130) arranged to carry out a measurement procedure in a course of operation of the rechargeable battery assembly (100), the measurement procedure comprising the measurement subsystem (130) arranged to:
couple the current shaping assembly (120, 140) to said current path and operate the current shaping assembly (120, 140) to vary an electric current in said current path over a measurement period according to a switching sequence defined by a multi-frequency pseudo-random pulse sequence, PRPS, that represents a plurality of frequency components at a predefined frequency resolution within a predefined frequency range and that defines switching between different current levels as a function of time,
obtain measurement data that comprises a respective indication of a respective cell-unit-specific voltage across each cell unit (111-k) of the plurality of cell units (111) as a function of time and an indication of the electric current in said current path as a function of time over the measurement period,
derive a respective cell-unit-specific impedance of each cell unit (111-k) based on the measurement data, and
determine, based on the derived impedances, at least one status indication that pertains to a condition of the battery module (110).

2. A rechargeable battery assembly (100) according to claim 1 wherein the current shaping assembly (120, 140) comprises an adjustable load (120) that is selectively couplable to said current path such that it is coupled in parallel to the battery module (110) and that enables varying the electric current in said current path over a measurement period by setting an impedance of the adjustable load (120) to one of two or more predefined impedance values according to said switching sequence.

3. A rechargeable battery assembly (100', 100") according to claim 1 wherein the current shaping assembly (120, 140) comprises an adjustable load (120) that is selectively couplable to said current path such that it is coupled in series with the battery module (110) and that enables varying the electric current in said current path over a measurement period by setting an impedance of the adjustable load (120) to one of two or more predefined impedance values according to said switching sequence.

4. A rechargeable battery assembly (100") according to claim 1, wherein the current shaping assembly (120, 140) comprises a temporary charge storage (140) that is selectively couplable to said current path such that it is coupled in parallel to the battery module (110) and that enables varying the electric current in said current path over a measurement period by the measurement subsystem (130) alternating between at least two of the following operation modes of the temporary charge storage 140 according to said switching sequence:
operate the temporary charge storage (140) to discharge electrical energy from the battery module (110) for storage in the temporary charge storage (140);
operate the temporary charge storage (140) to discharge electrical energy from the temporary charge storage (140) for storage in the battery module (110); and
refrain from transferring electrical energy between the battery module (110) and the temporary charge storage (140).

5. A rechargeable battery assembly (100") according to claim 4, wherein the temporary charge storage (140) comprises one or more capacitors that are selectively couplable in parallel to the battery module (110) to one of receive electrical energy from the battery module (110) or supply electrical energy to the battery module (110) under control of the measurement subsystem (130).

6. A rechargeable battery assembly (100, 100, 100") according to any of claims 1 to 5, wherein the measurement subsystem (130) is arranged to carry out the measurement procedure when the battery module (110) does not supply or receive an electric current through the first and second terminals **(Nₐ, N_{b}).**

7. A rechargeable battery assembly (100, 100', 100") according to any of claims 1 to 6, wherein one of the following applies:
the measurement subsystem (130) is arranged to carry out the measurement procedure when the battery module (110) receives a charging current via said current path from an external charger apparatus (160) coupled to said first and second terminals **(Nₐ, N_{b});**
the measurement subsystem (130) is arranged to carry out the measurement procedure when supplying an electric current from the battery module (110) via said current path to an external load (150) coupled to said first and second terminals **(Nₐ, N_{b}).**

8. A rechargeable battery assembly (100, 100', 100") according to any of claims 1 to 7, wherein the measurement subsystem (130) is arranged to carry out the measurement procedure according to a predefined schedule and/or in response to a user input.

9. A rechargeable battery assembly (100, 100', 100") according to any of claims 1 to 8, wherein the measurement subsystem (130) is arranged to:
obtain a respective indication of a respective cell-unit specific voltage across each cell unit (111-k) of the plurality of cell units (111) for a given time instant;
compare the cell-unit-specific voltages obtained for the given time instant to a reference voltage; and
carry out the measurement procedure in response to at least one of said cell-unit-specific voltages differing from the reference voltage by more than a predefined margin.

10. A rechargeable battery assembly (100, 100', 100") according to claim 9, wherein the reference voltage is one of the following:
a predefined refence voltage,
an average of the cell-unit-specific voltages obtained for the given time instant,
a median of the cell-unit-specific voltages obtained for the given time instant.

11. A rechargeable battery assembly (100, 100', 100") according to any of claims 1 to 10, wherein the measurement procedure comprises the measurement subsystem (130) arranged to determine the at least one status indication via:
determining, for each cell unit (111-k), based on the cell-unit-specific impedance derived therefor, a respective impedance curve that is descriptive of an impedance of the respective cell unit (111-k) as a function of frequency over the predefined frequency range; and
determine, based on said impedance curves, a respective status indication for one or more cell units (111-k) of the plurality of cell units (111).

12. A rechargeable battery assembly (100, 100', 100") according to claim 11, where the measurement procedure comprises the measurement subsystem (130) arranged to determine the respective status indication for said one or more cell units (111-k) via:
determining the respective status indication for each of the plurality of cell units (111) as the respective impedance curve determined therefor, and
storing data that defines the respective impedance curves determined for the plurality of cell units (111) to a memory within the rechargeable battery assembly (100, 100').

13. A rechargeable battery assembly (100, 100', 100") according to claim 11 or 12, where the measurement procedure comprises the measurement subsystem (130) arranged to determine the respective status indication for said one or more cell units (111-k) by:
deriving respective one or more impedance characteristics for each cell unit (111-k) based on the impedance curve determined therefor, and
determining, in response to the one or more impedance characteristics derived for a given cell unit (111-k) deviating from respective one or more reference impedance characteristics, a respective status indication that indicates compromised condition of the respective cell unit (111-k).

14. A rechargeable battery assembly (100, 100', 100") according to claim 13, wherein said one or more reference impedance characteristics comprise one of the following:
predefined one or more reference impedance characteristics,
representative one or more impedance characteristics determined based on the respective one or more impedance characteristics derived for the plurality of cell units (111).

15. A rechargeable battery assembly (100, 100', 100") according to claim 14, wherein said representative one or more impedance characteristics comprise one of the following:
an average of the respective impedance characteristics determined for the plurality of cell units (111),
a median of the respective impedance characteristics determined for the plurality of cell units (111).

## Amended claims

### Amended claims in accordance with Rule 137(2) EPC.

1. A rechargeable battery assembly (100, 100', 100") comprising:
a battery module (110) comprising a plurality of cell units (111) connected in series between a first terminal (Nₐ) and a second terminal (N_{b});
a current shaping assembly (120, 140) selectively couplable to a current path through the battery module (110); and
a measurement subsystem (130) arranged to carry out a measurement procedure in a course of operation of the rechargeable battery assembly (100), the measurement procedure comprising the measurement subsystem (130) arranged to:
couple the current shaping assembly (120, 140) to said current path and operate the current shaping assembly (120, 140) to vary an electric current in said current path over a measurement period according to a switching sequence defined by a multi-frequency pseudo-random pulse sequence, PRPS, that represents a plurality of frequency components at a predefined frequency resolution within a predefined frequency range and that defines switching between different current levels as a function of time,
obtain measurement data that comprises a respective indication of a respective cell-unit-specific voltage across each cell unit (111-k) of the plurality of cell units (111) as a function of time and an indication of the electric current in said current path as a function of time over the measurement period,
derive a respective cell-unit-specific impedance of each cell unit (111-k) based on the measurement data, and
determine, based on the derived impedances, at least one status indication that pertains to a condition of the battery module (110)
**characterized in that** the measurement subsystem (130) is arranged to:
obtain a respective indication of a respective cell-unit specific voltage across each cell unit (111-k) of the plurality of cell units (111) for a given time instant;
compare the cell-unit-specific voltages obtained for the given time instant to a reference voltage; and
carry out the measurement procedure in response to at least one of said cell-unit-specific voltages differing from the reference voltage by more than a predefined margin.

2. A rechargeable battery assembly (100) according to claim 1 wherein the current shaping assembly (120, 140) comprises an adjustable load (120) that is selectively couplable to said current path such that it is coupled in parallel to the battery module (110) and that enables varying the electric current in said current path over a measurement period by setting an impedance of the adjustable load (120) to one of two or more predefined impedance values according to said switching sequence.

3. A rechargeable battery assembly (100', 100") according to claim 1 wherein the current shaping assembly (120, 140) comprises an adjustable load (120) that is selectively couplable to said current path such that it is coupled in series with the battery module (110) and that enables varying the electric current in said current path over a measurement period by setting an impedance of the adjustable load (120) to one of two or more predefined impedance values according to said switching sequence.

4. A rechargeable battery assembly (100") according to claim 1, wherein the current shaping assembly (120, 140) comprises a temporary charge storage (140) that is selectively couplable to said current path such that it is coupled in parallel to the battery module (110) and that enables varying the electric current in said current path over a measurement period by the measurement subsystem (130) alternating between at least two of the following operation modes of the temporary charge storage 140 according to said switching sequence:
operate the temporary charge storage (140) to discharge electrical energy from the battery module (110) for storage in the temporary charge storage (140);
operate the temporary charge storage (140) to discharge electrical energy from the temporary charge storage (140) for storage in the battery module (110); and
refrain from transferring electrical energy between the battery module (110) and the temporary charge storage (140).

5. A rechargeable battery assembly (100") according to claim 4, wherein the temporary charge storage (140) comprises one or more capacitors that are selectively couplable in parallel to the battery module (110) to one of receive electrical energy from the battery module (110) or supply electrical energy to the battery module (110) under control of the measurement subsystem (130).

6. A rechargeable battery assembly (100, 100, 100") according to any of claims 1 to 5, wherein the measurement subsystem (130) is arranged to carry out the measurement procedure when the battery module (110) does not supply or receive an electric current through the first and second terminals (Nₐ, N_{b}).

7. A rechargeable battery assembly (100, 100', 100") according to any of claims 1 to 6, wherein one of the following applies:
the measurement subsystem (130) is arranged to carry out the measurement procedure when the battery module (110) receives a charging current via said current path from an external charger apparatus (160) coupled to said first and second terminals (Nₐ, N_{b});
the measurement subsystem (130) is arranged to carry out the measurement procedure when supplying an electric current from the battery module (110) via said current path to an external load (150) coupled to said first and second terminals (Nₐ, N_{b}).

8. A rechargeable battery assembly (100, 100', 100") according to any of claims 1 to 7, wherein the measurement subsystem (130) is arranged to carry out the measurement procedure according to a predefined schedule and/or in response to a user input.

9. A rechargeable battery assembly (100, 100', 100") according to any of claims 1 to 8, wherein the reference voltage is one of the following:
a predefined reference voltage,
an average of the cell-unit-specific voltages obtained for the given time instant,
a median of the cell-unit-specific voltages obtained for the given time instant.

10. A rechargeable battery assembly (100, 100', 100") according to any of claims 1 to 9, wherein the measurement procedure comprises the measurement subsystem (130) arranged to determine the at least one status indication via:
determining, for each cell unit (111-k), based on the cell-unit-specific impedance derived therefor, a respective impedance curve that is descriptive of an impedance of the respective cell unit (111-k) as a function of frequency over the predefined frequency range; and determine, based on said impedance curves, a respective status indication for one or more cell units (111-k) of the plurality of cell units (111).

11. A rechargeable battery assembly (100, 100', 100") according to claim 10, where the measurement procedure comprises the measurement subsystem (130) arranged to determine the respective status indication for said one or more cell units (111-k) via:
determining the respective status indication for each of the plurality of cell units (111) as the respective impedance curve determined therefor, and
storing data that defines the respective impedance curves determined for the plurality of cell units (111) to a memory within the rechargeable battery assembly (100, 100').

12. A rechargeable battery assembly (100, 100', 100") according to claim 10 or 12, where the measurement procedure comprises the measurement subsystem (130) arranged to determine the respective status indication for said one or more cell units (111-k) by:
deriving respective one or more impedance characteristics for each cell unit (111-k) based on the impedance curve determined therefor, and
determining, in response to the one or more impedance characteristics derived for a given cell unit (111-k) deviating from respective one or more reference impedance characteristics, a respective status indication that indicates compromised condition of the respective cell unit (111-k).

13. A rechargeable battery assembly (100, 100', 100") according to claim 12, wherein said one or more reference impedance characteristics comprise one of the following:
predefined one or more reference impedance characteristics,
representative one or more impedance characteristics determined based on the respective one or more impedance characteristics derived for the plurality of cell units (111).

14. A rechargeable battery assembly (100, 100', 100") according to claim 13, wherein said representative one or more impedance characteristics comprise one of the following:
an average of the respective impedance characteristics determined for the plurality of cell units (111),
a median of the respective impedance characteristics determined for the plurality of cell units (111).

15. A method (200) in a measurement subsystem (130) of a rechargeable battery assembly (100, 100', 100") that comprises a battery module (110) comprising a plurality of cell units (111) connected in series between a first terminal (Nₐ) and a second terminal (N_{b}), a current shaping assembly (120, 140) selectively couplable to a current path through the battery module (110), and the measurement subsystem (130), where the method (200) comprises carrying out, in a course of operation of the rechargeable battery assembly (100), a measurement procedure comprising:
coupling (202) the current shaping assembly (120, 140) to said current path and operate the current shaping assembly (120, 140) to vary an electric current in said current path over a measurement period according to a switching sequence defined by a multi-frequency pseudo-random pulse sequence, PRPS, that represents a plurality of frequency components at a predefined frequency resolution within a predefined frequency range and that defines switching between different current levels as a function of time,
obtaining (204) measurement data that comprises a respective indication of a respective cell-unit-specific voltage across each cell unit (111-k) of the plurality of cell units (111) as a function of time and an indication of the electric current in said current path as a function of time over the measurement period;
deriving (206) a respective cell-unit-specific impedance of each cell unit (111-k) based on the measurement data; and
determining (208), based on the derived impedances, at least one status indication that pertains to a condition of the battery module (110),
**characterized in that** the method (200) comprises:
obtaining a respective indication of a respective cell-unit specific voltage across each cell unit (111-k) of the plurality of cell units (111) for a given time instant;
comparing the cell-unit-specific voltages obtained for the given time instant to a reference voltage; and
carrying out the measurement procedure in response to at least one of said cell-unit-specific voltages differing from the reference voltage by more than a predefined margin.
